# DEMANDE DE BREVET EUROPEEN

(11) **EP 1 256 984 A2**
(43) Date de publication de la demande: **13.11.2002**
(21) Numéro de dépôt: 02354079.2
(22) Date de dépôt: 07.05.2002
(51) Int. Cl.: H01L 27/144, H01L 27/146, H01L 31/0352, H01L 31/0376

(54) **Photod-tecteur CMOS comportant une photodiode en silicium amorphe**

(30) Priorité: 09.05.2001 FR 0106131
(71) Demandeur: STMicroelectronics S.A., 92120 Montrouge (FR)
(72) Inventeur: Cazaux, Yvon, 38100 Grenoble (FR)
(74) Mandataire: de Beaumont, Michel

(57) **Abrégé**

L'invention concerne un photodétecteur comportant une photodiode (D) en silicium amorphe dont l'anode est reliée à un potentiel de référence (VSS), un transistor MOS d'initialisation (T1) connecté entre la cathode de la photodiode et un premier potentiel d'alimentation (VDD) pour mettre la cathode au premier potentiel d'alimentation pendant une phase d'initialisation, et des moyens de mesure (T2, T3) du potentiel de la cathode de la photodiode (D), comprenant des moyens (T1, 30) pour amener la cathode de la photodiode à un potentiel de saturation (Vraz) proche du potentiel de référence immédiatement avant la phase d'initialisation.

## Description

La présente invention concerne la réalisation sous forme monolithique de capteurs d'images destinés à être utilisés dans des dispositifs de prise de vues tels que, par exemple, des caméras, des camescopes ou encore des appareils photographiques numériques. Plus particulièrement, la présente invention concerne des capteurs d'images réalisés en technologie CMOS.

Un capteur d'images réalisé en technologie CMOS comprend généralement une matrice de photodétecteurs disposés à l'intersection de lignes et de colonnes.

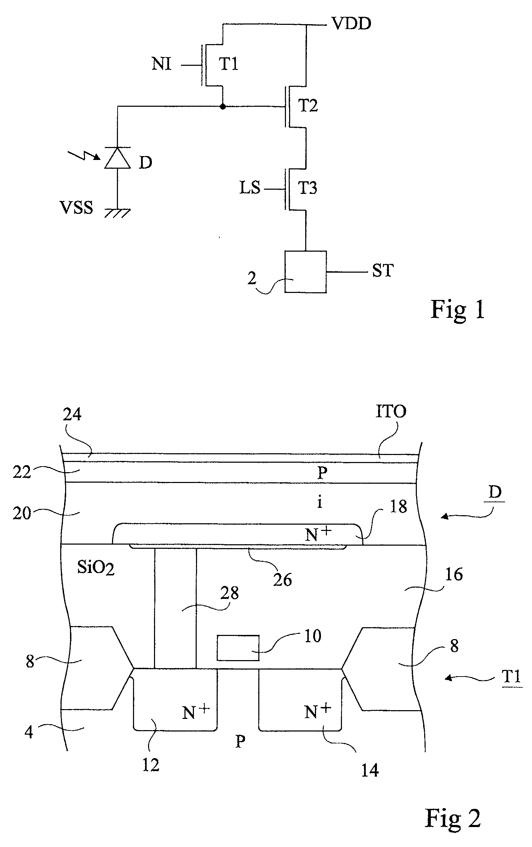

La figure 1 représente schématiquement un exemple de photodétecteur de type CMOS d'une matrice d'un capteur d'images. Une photodiode D a son anode reliée à un potentiel bas de référence VSS. La cathode de la photodiode D est reliée à un noeud de détection SN. Un transistor MOS d'initialisation T1 et un transistor MOS de mesure T2, à canal N, ont leur drain relié à un potentiel haut d'alimentation VDD. La source du transistor T1 et la grille du transistor T2 sont reliées au noeud de détection SN. La grille du transistor T1 reçoit un signal NI de commande d'initialisation du noeud SN. Un transistor MOS de commande T3 à canal N a son drain relié à la source du transistor T2. La grille du transistor T3 reçoit un signal de sélection de ligne LS. La source du transistor T3 est reliée à un moyen de lecture 2. Le moyen de lecture 2 reçoit un signal de commande de lecture ST. Le moyen 2 est relié à d'autres photodiodes non représentées de la matrice.

La photodiode D d'un photodétecteur tel qu'en figure 1 peut être réalisée dans le même substrat que les autres éléments du photodétecteur. Sa surface réceptrice de lumière doit être suffisante pour assurer une bonne détection, la surface occupée par les autres éléments du photodétecteur réduisant le nombre de photons captés par la photodiode. Pour augmenter la surface de la photodiode sans augmenter la surface totale d'un photodétecteur, une solution consiste à réaliser la photodiode au dessus de l'ensemble des autres éléments du photodétecteur.

La figure 2 représente schématiquement à titre d'exemple une vue en coupe d'une photodiode D et d'un transistor MOS d'initialisation T1 d'un photodétecteur, dans lequel la photodiode est formée au-dessus des autres éléments du photodétecteur. Pour des raisons de lisibilité, les figures représentant les différentes régions de semiconducteur ne sont pas tracées à l'échelle. Le transistor T1 est réalisé dans une zone active 4 de type P délimitée par une zone d'isolement de champ 8 en oxyde de silicium (SiO₂). De part et d'autre d'une grille isolée 10, se trouvent des régions de type N de source 12 et de drain 14 du transistor T1. Le transistor T1 est recouvert d'une couche d'isolant (SiO₂) 16. Au-dessus de la couche 16 est formée une couche de silicium amorphe comprenant une région inférieure 18, une couche intermédiaire 20 intrinsèque et une couche supérieure 22 de type P, pour constituer une photodiode de type PIN. La couche 22 forme l'anode de la photodiode et la région 18 forme la cathode de la photodiode. La couche 22 est recouverte d'une couche 24 conductrice et transparente d'ITO reliée au potentiel VSS. La région 18 est reliée par un via conducteur 28 à la région de source 12. Une région conductrice 26 peut être disposée sous la région 18.

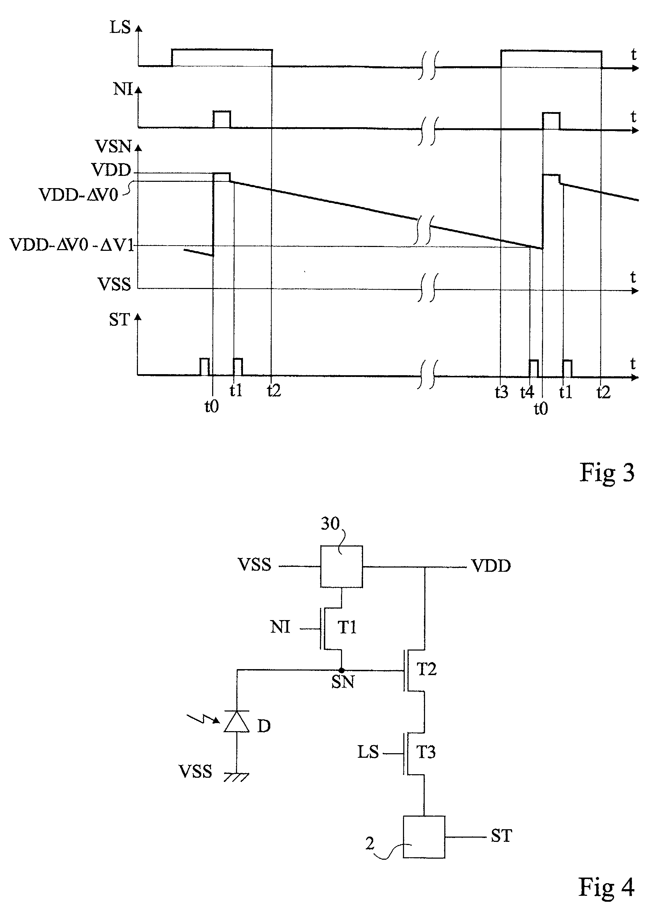

La figure 3 illustre, lors d'une phase de mesure de la lumière reçue par le photodétecteur de la figure 1, les variations en fonction du temps des signaux LS et NI, du potentiel VSN du noeud SN, et du signal ST. Le transistor T2 est connecté en montage suiveur du potentiel VSN du noeud SN. Pour des raisons de simplicité, on considère par la suite que le transistor T2 présente un gain unitaire et que le potentiel de la source du transistor T2 est sensiblement égal au potentiel VSN. On considère ainsi que le moyen de lecture 2, relié à la source du transistor T2 par l'intermédiaire du transistor T3, permet de mémoriser le potentiel VSN.

A un instant t0, le signal de sélection LS est à 1 de telle manière que le transistor T3 est conducteur et que la source du transistor T2 est reliée au moyen de lecture 2. Le signal de lecture ST est à 0 et le moyen de lecture 2 est inactivé. A l'instant t0, le signal d'initialisation NI est amené à 1, pour une brève durée d'initialisation, de manière à amener le potentiel VSN à VDD. A l'issue de cette initialisation, le signal NI revient à 0. Le potentiel VSN chute alors d'un potentiel ΔV0 dû notamment au couplage capacitif existant entre la grille et la source du transistor T1, ainsi qu'à du bruit introduit par le transistor T1.

A un instant t1, après que le signal NI est revenu à 0, le signal ST est activé un bref instant pour commander la lecture du potentiel VDD-ΔV0 par le moyen 2. A partir de l'instant où le transistor T1 n'est plus conducteur et où la cathode de la photodiode n'est plus reliée à VDD, et si la photodiode D est soumise à un rayonnement lumineux, des électrons viennent s'accumuler au niveau de la cathode de la photodiode. Le potentiel VSN de la cathode décroît alors proportionnellement à la lumière reçue.

A un instant t2, le signal LS est amené à 0 de manière à rendre le transistor T3 non conducteur et à isoler le photodétecteur du moyen 2. Le moyen 2 peut alors être relié à un autre photodétecteur du capteur d'images.

A un instant t3, après une durée prédéterminée pendant laquelle la photodiode est soumise à un rayonnement lumineux que l'on veut mesurer, le signal LS est à nouveau amené à 1 et le transistor T3 est rendu conducteur.

A un instant t4, le signal ST est brièvement activé de manière à commander la lecture du potentiel VSN par le moyen 2. Le potentiel VSN a alors une valeur VDD-ΔV0-ΔV1, où ΔV1 dépend du nombre de photons reçus par la photodiode et d'un bruit thermique négligeable. La mesure de VDD-ΔV0-ΔV1 est soustraite à la mesure précédente de VDD-ΔV0 pour connaître la valeur ΔV1 et ainsi la lumière reçue par la photodiode entre les instants t1 et t4.

Une photodiode en silicium amorphe comporte des pièges de charge susceptibles de stocker des électrons pendant une durée dite temps de relaxation. Lors de chaque phase de mesure de lumière telle que décrite en figure 3, une partie des électrons accumulés dans la cathode de la photodiode entre les instants t1 et t4 se trouve immobilisée par les pièges de charge de la photodiode. La valeur ΔV1 mesurée à l'issue de la phase de mesure ne prend pas en compte les électrons stockés dans les pièges de charge, et la mesure est faussée. En outre, la durée de connexion au potentiel VDD pendant la phase d'initialisation est insuffisante pour vider tous les pièges de charge. Ainsi, au début de chaque phase de mesure, des pièges de charge contiennent une quantité d'électrons parasites qui dépend de la lumière reçue lors d'une ou plusieurs phases de mesure précédentes. Ces électrons parasites, libérés à l'issue du temps de relaxation des pièges de charge, faussent la valeur ΔV1 mesurée. La valeur ΔV1 mesurée à l'issue de chaque phase de mesure dépend ainsi en partie de la lumière reçue lors de la ou des phases de mesure précédentes. Dans un capteur d'images comprenant une matrice de photodétecteurs, ce phénomène de rétention des électrons donne lieu à une rémanence ou à un traînage de l'image. L'importance du traînage dépend notamment de la quantité de pièges dans la photodiode et de la durée moyenne de rétention des électrons par ces pièges.

Une solution connue pour supprimer ce phénomène de traînage consiste à limiter le nombre de pièges dans la photodiode D. Cette solution implique de réaliser la photodiode D dans un silicium amorphe réalisé de façon spécifique, et implique un allongement coûteux de la durée de fabrication du circuit.

Un objet de la présente invention est de prévoir un photodétecteur CMOS comportant une photodiode en silicium amorphe de structure simple, peu coûteux à fabriquer, et qui ne donne pas lieu à un phénomène de traînage tel que décrit précédemment.

Pour atteindre cet objet, la présente invention prévoit un photodétecteur comportant une photodiode en silicium amorphe dont l'anode est reliée à un potentiel de référence, un transistor MOS d'initialisation connecté entre la cathode de la photodiode et un premier potentiel d'alimentation pour mettre la cathode au premier potentiel d'alimentation pendant une phase d'initialisation, et des moyens de mesure du potentiel de la cathode de la photodiode, comprenant des moyens de saturation pour amener la cathode de la photodiode à un potentiel de saturation proche du potentiel de référence immédiatement avant la phase d'initialisation.

Selon un mode de réalisation de la présente invention, la source du transistor MOS d'initialisation est reliée à la cathode de la photodiode et le photodétecteur comprend un moyen d'aiguillage propre à amener le drain du transistor MOS d'initialisation au potentiel de saturation ou au premier potentiel d'alimentation.

Selon un mode de réalisation de la présente invention, le transistor MOS d'initialisation est commandé en régime de faible inversion.

Selon un mode de réalisation de la présente invention, le transistor MOS d'initialisation est commandé en régime de forte inversion.

Selon un mode de réalisation de la présente invention, les moyens de mesure comprennent un transistor MOS de mesure dont la grille est reliée à la cathode de la photodiode, et un transistor MOS de commande relié en série avec le transistor MOS de mesure entre un second potentiel d'alimentation et un moyen de lecture.

Selon un mode de réalisation de la présente invention, les premier et second potentiels d'alimentation sont égaux.

La présente invention vise également un procédé de mesure de la lumière reçue par un photodétecteur comportant une photodiode en silicium amorphe dont l'anode est reliée à un potentiel de référence, comportant les étapes successives consistant à :
a/ amener la cathode de la photodiode à un potentiel de saturation proche du potentiel de référence ;
b/ amener la cathode de la photodiode à un potentiel d'alimentation, puis isoler électriquement la cathode ;
c/ effectuer une première mesure du potentiel de la cathode de la photodiode immédiatement après l'isolation électrique de la cathode ;
d/ soumettre la photodiode à un rayonnement lumineux pendant une durée déterminée ; et
e/ effectuer une seconde mesure du potentiel de la cathode de la photodiode et soustraire la seconde mesure de la première mesure.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente un circuit de photodétecteur de type CMOS ;
la figure 2, précédemment décrite, représente schématiquement une vue en coupe du photodétecteur de la figure 1 ;
la figure 3, précédemment décrite, illustre le fonctionnement du photodétecteur de la figure 1 ;
la figure 4 représente schématiquement un circuit de photodétecteur selon la présente invention ; et
la figure 5 illustre le fonctionnement du photodétecteur de la figure 4.

De mêmes éléments ont été désignés par les mêmes références aux différentes figures. Seuls les éléments nécessaires à la compréhension de la présente invention ont été représentés aux différentes figures.

La figure 4 représente schématiquement un circuit de photodétecteur selon la présente invention. Le photodétecteur comprend une photodiode D en silicium amorphe de type PIN et un transistor T1 tels que représentés en figure 2. La grille du transistor T1 reçoit un signal de commande NI. Selon la présente invention, le drain du transistor T1 est relié à un aiguilleur 30, commandable par des moyens non représentés, prévu pour amener le drain du transistor T1 au potentiel VDD ou au potentiel VSS. Un transistor MOS de mesure T2 à canal N a son drain relié au potentiel VDD et sa grille reliée à la cathode SN de la photodiode D. Un transistor de commande T3, de type N est connecté entre la source du transistor T2 et un moyen de lecture 2 commandé par un signal ST. La grille du transistor T3 reçoit un signal de commande LS.

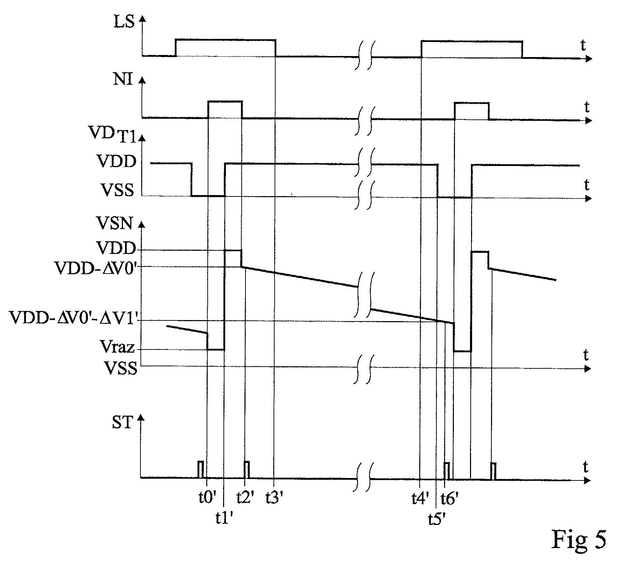

La figure 5 illustre, lors d'une phase de mesure de la lumière reçue par la photodiode du détecteur de la figure 4, l'évolution en fonction du temps des signaux LS et NI, du potentiel VD_{T1} du drain du transistor T1, du potentiel VSN de la cathode de la photodiode D, et du signal de commande ST.

A un instant t0', au début de la phase de mesure, le signal LS est à un niveau 1 de telle manière que le transistor T3 est conducteur. L'aiguilleur 30 est dans un état tel que le drain du transistor T1 est relié au potentiel VSS. A l'instant t0', le signal NI est amené à 1 de manière à rendre le transistor T1 conducteur et à amener la cathode SN de la photodiode à un potentiel bas Vraz. Le potentiel Vraz est sensiblement égal au potentiel VSS augmenté de la tension de seuil VT du transistor T1. Abaisser le potentiel de la cathode SN au potentiel Vraz équivaut à fournir une grande quantité d'électrons à la cathode SN. La cathode SN est maintenue au potentiel Vraz jusqu'à un instant t1' pendant une durée suffisante pour que les niveaux de pièges de charge de la cathode soient "saturés". Ainsi, à chaque instant t1', les pièges de charge se retrouvent dans un état de rétention maximum déterminé, quel qu'ait été l'éclairement antérieur de la photodiode. On efface ainsi la "mémoire" de l'image précédente contenue dans les pièges de la photodiode de silicium amorphe.

A l'instant t1', l'aiguilleur 30 est commandé de manière à amener le drain du transistor T1 au potentiel VDD. La cathode de la photodiode est alors amenée à un potentiel sensiblement égal au potentiel VDD. Cette étape correspond à une initialisation de la photodiode avant que ne démarre une nouvelle phase d'intégration. Après une durée d'initialisation prédéterminée, le signal NI est amené à 0. Le potentiel VSN chute alors d'une tension ΔV0' due notamment au couplage capacitif entre la grille et la source du transistor T1.

A un instant t2', peu après que le signal NI ait été amené à 0, le moyen 2 est commandé pour mémoriser la valeur VDD-ΔV0' du potentiel VSN.

A un instant t3', le signal LS est amené à 0 de manière à rendre le transistor T3 non conducteur. Le moyen de lecture 2 est alors isolé du photodétecteur et il peut être connecté à un autre photodétecteur de la matrice.

A un instant t4', après une durée prédéterminée pendant laquelle la photodiode est soumise à un rayonnement lumineux, le signal LS est amené à 1 de manière à rendre le transistor T3 conducteur et à relier le moyen de lecture 2 au photodétecteur.

A un instant t5', l'aiguilleur 30 est commandé pour amener le drain du transistor au potentiel VSS.

A un instant t6', le moyen 2 est commandé pour mémoriser le potentiel du noeud SN, égal à VDD-ΔV0'-ΔV1'. Tous les pièges de charge étant initialement saturés, la quantité d'électrons qu'ils libèrent entre les instants t2' et t6' est indépendante de la ou des phases de mesure précédentes. Si l'on considère que la quantité d'électrons libérée par les pièges ne fluctue pas avec le temps, la tension ΔV1' ne varie qu'en fonction de la lumière reçue par la photodiode entre les instants t2' et t4'. La soustraction des mesures faites aux instants t6' et t2' permet de déterminer la valeur ΔV1'. Un photodétecteur selon la présente invention permet ainsi de fournir un potentiel dont la variation ne dépend que de la lumière reçue pendant chaque période de mesure, ce qui permet de supprimer le phénomène de traînage exposé précédemment.

Pour des raisons de simplicité, la présente invention a été décrite dans le cas où la quantité d'électrons libérée par les pièges ne fluctue pas avec le temps. En pratique, cette quantité d'électrons peut fluctuer et introduire un bruit temporel dans la mesure de la lumière reçue par la photodiode.

Pour des raisons de simplicité, la présente invention a été décrite dans le cas où le potentiel Vraz permet de saturer l'ensemble des pièges de charge de la cathode de la photodiode. En pratique, une quasi-saturation suffira.

Bien entendu, la présente invention est susceptible de diverses variantes et modifications qui apparaîtront à l'homme du métier. En particulier, la présente invention a été décrite en relation avec un type de photodiode en silicium amorphe particulier, mais l'homme du métier adaptera sans difficultés la présente invention à tout type de photodiode en silicium amorphe, et plus généralement à tout type de photodiode comportant des pièges de charge.

La présente invention a été décrite en relation avec un séquencement particulier des opérations de saturation des pièges de charges de la photodiode, d'initialisation et de mesure du potentiel de la cathode de la photodiode, mais l'homme du métier adaptera sans difficultés la présente invention à d'autres séquencements. A titre d'exemple, l'opération de saturation des pièges de charge de la photodiode peut être réalisée au milieu de la phase d'initialisation du potentiel de la photodiode. De même, les durées des différentes phases n'ont pas été précisées, mais l'homme du métier les déterminera sans difficultés.

La présente invention a été décrite en relation avec des commandes en tout-ou-rien, ou forte inversion, du transistor T1, mais l'homme du métier adaptera sans difficultés la présente invention à des commandes en faible inversion du transistor T1, par exemple pour réduire le bruit introduit par les transistors.

La présente invention a été décrite en relation avec un cas où le transistor T2 présente un gain unitaire et où le potentiel de la source du transistor T2 est sensiblement égal au potentiel VSN, mais l'homme du métier adaptera sans difficultés la présente invention à un cas où le transistor T2 présente un gain non unitaire et où le potentiel de la source du transistor T2 n'est pas égal au potentiel VSN.

La présente invention a été décrite en relation avec des transistors à canal N, mais l'homme du métier adaptera sans difficultés la présente invention à des transistors à canal P.

La présente invention a été décrite en relation avec un cas dans lequel le drain du transistor T1 peut être amené à un potentiel haut VDD identique au potentiel haut auquel le drain du transistor T2 est relié, mais l'homme du métier adaptera sans difficultés la présente invention à un cas dans lequel ces deux potentiels hauts sont différents.

## Revendications

1. Photodétecteur comportant :
une photodiode (D) en silicium amorphe dont l'anode est reliée à un potentiel de référence (VSS) ;
un transistor MOS d'initialisation (T1) connecté entre la cathode de la photodiode et un premier potentiel d'alimentation (VDD) pour mettre la cathode au premier potentiel d'alimentation pendant une phase d'initialisation ; et
des moyens de mesure (T2, T3) du potentiel de la cathode de la photodiode (D) ;
**caractérisé en ce qu'**il comprend des moyens de saturation (T1, 30) pour amener la cathode de la photodiode à un potentiel de saturation (Vraz) proche du potentiel de référence immédiatement avant la phase d'initialisation.

2. Photodétecteur selon la revendication 1, dans lequel la source du transistor MOS d'initialisation (T1) est reliée à la cathode de la photodiode (D) et comprenant un moyen d'aiguillage (30) propre à amener le drain du transistor MOS d'initialisation (T1) au potentiel de saturation (Vraz) ou au premier potentiel d'alimentation (VDD).

3. Photodétecteur selon la revendication 2, dans lequel le transistor MOS d'initialisation (T1) est commandé en régime de faible inversion.

4. Photodétecteur selon la revendication 2, dans lequel le transistor MOS d'initialisation (T1) est commandé en régime de forte inversion.

5. Photodétecteur selon les revendications 2 à 4, dans lequel les moyens de mesure comprennent :
un transistor MOS de mesure (T2) dont la grille est reliée à la cathode de la photodiode ; et
un transistor MOS de commande (T3) relié en série avec le transistor MOS de mesure (T2) entre un second potentiel d'alimentation (VDD) et un moyen de lecture (2).

6. Photodétecteur selon la revendication 5, dans lequel les premiers et second potentiels d'alimentation (VDD) sont égaux.

7. Procédé de mesure de la lumière reçue par un photodétecteur comportant une photodiode (D) en silicium amorphe dont l'anode est reliée à un potentiel de référence (GND) ; comportant les étapes successives consistant à :
a/ amener la cathode de la photodiode à un potentiel de saturation proche du potentiel de référence ;
b/ amener la cathode de la photodiode à un potentiel d'alimentation, puis isoler électriquement la cathode (VDD) ;
c/ effectuer une première mesure du potentiel de la cathode de la photodiode immédiatement après l'isolation électrique de la cathode ;
d/ soumettre la photodiode (D) à un rayonnement lumineux pendant une durée déterminée ; et
e/ effectuer une seconde mesure du potentiel de la cathode de la photodiode (D) et soustraire la seconde mesure de la première mesure.
